# EUROPEAN PATENT APPLICATION

(11) **EP 4 808 001 A1**
(43) Date of publication of application: **16.09.2026**
(21) Application number: 24887885.2
(22) Date of filing: 01.11.2024
(51) Int. Cl.: H04B 1/74

(54) **OVERVOLTAGE PROTECTION METHOD FOR RADIO FREQUENCY FRONT-END MODULE, AND ELECTRONIC DEVICE**

(30) Priority: 06.11.2023 CN 202311461011
(71) Applicant: Vanchip (Tianjin) Technology Co. Ltd, Tianjin 300457 (CN)
(72) Inventor: LI, Hao, Tianjin 300457 (CN); ZHANG, Xiaobo, Tianjin 300457 (CN)
(74) Representative: Wang, Bo
(86) International application number: PCT/CN2024/129525
(87) International publication number: WO 2025/098273

(57) **Abstract**

The present invention discloses an overvoltage protection method for a radio frequency front-end module and an electronic device. The overvoltage protection method includes the following steps: monitoring a power supply voltage in real time; determining whether the power supply voltage reaches a first voltage threshold; starting counting a first time; determining whether the first time reaches a first time threshold; causing the radio frequency front-end module to enter an overvoltage protection mode; reducing, by an analog control circuit, a gain of a power amplifier or turning off the power amplifier; determining whether the power supply voltage reaches a fifth voltage threshold; starting counting a second time; determining whether the second time reaches a second time threshold; causing the radio frequency front-end module to exit the overvoltage protection mode; and enabling, by the analog control circuit, the power amplifier to restore low-gain operation or normal operation. By means of the present invention, effective protection on radio frequency front-end modules is implemented.

## Description

### BACKGROUND

### Technical Field

The present invention belongs to the technical field of radio frequency integrated circuits and relates to an overvoltage protection method for a radio frequency front-end module and also a corresponding radio frequency front-end module and an electronic device.

### Related Art

With the rapid development of 5G technology, radio frequency front-end architecture solutions are also continuously updated. Mainstream radio frequency front-end architecture solutions evolve from Phase5N to Phase7, to current Phase7L and Phase7LE, and currently planned Phase8. The architecture solutions of radio frequency front ends continuously evolve toward a high integration level and miniaturization. A radio frequency front-end module with a high integration level is mainly embodied in that it allows devices such as a power amplifier, a radio frequency switch, an analog control unit, a low noise amplifier, and a filter to be integrated into one module chip.

A module with a high integration level has advantages of the high integration level, a small radio frequency path loss, and reductions in a quantity of devices on an application side, an area of a PCB, and the like. Its main problem is how to ensure device reliability. When the device reliability is problematic, costs also significantly increase. However, low cost is also an important goal for the radio frequency front-end module. Therefore, optimizing the device reliability is a very important task. In the radio frequency front-end module, devices most prone to a reliability problem are the power amplifier and the filter. The power amplifier is prone to failure under conditions of high voltage, high power, and high or low temperature, and the filter is prone to failure under high power and high temperature. High-power conditions generally involve a high-voltage environment, and high or low temperatures tend to accelerate device failure. Therefore, to optimize the reliability of the device, a design for high voltage protection needs to be performed, and high voltage protection at a high temperature or a low temperature needs to be enhanced.

### SUMMARY

A first technical problem to be resolved by the present invention is to provide an overvoltage protection method for a radio frequency front-end module.

Another technical problem to be resolved by the present invention is to provide a radio frequency front-end module having an overvoltage protection function.

Still another technical problem to be resolved by the present invention is to provide an electronic device, including the radio frequency front-end module having an overvoltage protection function.

To achieve the foregoing objective, the present invention adopts the following technical solutions:
According to a first aspect of embodiments of the present invention, an overvoltage protection method for a radio frequency front-end module is provided, including the following steps:
(1) monitoring a power supply voltage of the radio frequency front-end module in real time;
(2) determining whether the power supply voltage reaches a first voltage threshold, where the method proceeds to a next step when the power supply voltage is greater than or equal to a first voltage threshold; or otherwise, the method proceeds to a previous step to continue monitoring the power supply voltage;
(3) starting timing, wherein a counted time is a first time, and the first time is a duration in which the power supply voltage is greater than or equal to the first voltage threshold;
(4) determining whether the first time reaches a first time threshold, where the method proceeds to a next step when the first time is greater than or equal to the first time threshold;
(5) causing the radio frequency front-end module to enter an overvoltage protection mode, to reduce a gain of a power amplifier or turn off the power amplifier;
(6) determining whether the power supply voltage reaches a fifth voltage threshold, where the method proceeds to a next step when the power supply voltage is less than or equal to a fifth voltage threshold, or otherwise, the method proceeds to a previous step to maintain the overvoltage protection mode;
(7) starting timing, wherein a counted time is a second time, and the second time is a duration in which the power supply voltage is less than or equal to the fifth voltage threshold;
(8) determining whether the second time reaches a second time threshold, where the method proceeds to a next step when the second time is greater than or equal to the second time threshold;
(9) causing the radio frequency front-end module to exit the overvoltage protection mode, to restore the power amplifier to low-gain operation or normal operation; and
(10) returning to step (1), wherein the first voltage threshold is greater than the fifth voltage threshold.

Preferably, the method further includes enabling an overvoltage protection function before step (1).

Preferably, after the causing the radio frequency front-end module to enter the overvoltage protection mode in step (5), a logic control circuit controls a bias power supply circuit of the power amplifier to be turned off, so that the power amplifier stops operation; and
after the causing the radio frequency front-end module to exit the overvoltage protection mode in step (9), the logic control circuit controls the bias power supply circuit of the power amplifier to be turned on, so that the power amplifier is restored to normal operation.

Preferably, after the causing the radio frequency front-end module to enter the overvoltage protection mode in step (5), an attenuation enable control circuit enables an attenuation circuit, so that the gain of the power amplifier is reduced; and
after the causing the radio frequency front-end module to exit the overvoltage protection mode in step (9), the attenuation enable control circuit turns off the attenuation circuit, so that the power amplifier is restored to normal operation.

Preferably, after the causing the radio frequency front-end module to enter the overvoltage protection mode in step (5),
a first step of enabling, by the attenuation enable control circuit, the attenuation circuit to reduce the gain of the power amplifier;
a second step of starting timing, wherein a counted time is a third time, and the method proceeds to a next step when the third time reaches a third time threshold; and
a third step of controlling, by a logic control circuit, a bias power supply circuit of the power amplifier to be turned off to stop operation of the power amplifier.

After the causing the radio frequency front-end module to exit the overvoltage protection mode in step (9), the method includes the following substeps:
a first step of controlling, by the logic control circuit, the bias power supply circuit of the power amplifier to be turned on, and enabling, by the attenuation enable control circuit, the attenuation circuit to restore the low-gain operation of the power amplifier;
a second step of starting timing, wherein a counted time is a fourth time, and the method proceeds to a next step when the fourth time reaches a fourth time threshold; and
a third step of turning off, by the attenuation enable control circuit, the attenuation circuit to restore the normal operation of the power amplifier to keep a normal gain.

Preferably, after the causing the radio frequency front-end module to enter the overvoltage protection mode in step (5), the method includes the following substeps:
a first step of turning off a bias power supply of a preamplifier in the power amplifier to reduce the gain of the power amplifier;
a second step of starting timing, wherein a counted time is a third time, and the method proceeds to a next step when the third time reaches a third time threshold; and
a third step of turning off a bias power supply of a final amplifier in the power amplifier to stop operation of the power amplifier.

After the causing the radio frequency front-end module to exit the overvoltage protection mode in step (9), the method includes the following substeps:
a first step of turning on the bias power supply of the final amplifier in the power amplifier to restore the low-gain operation of the power amplifier;
a second step of starting timing, wherein a counted time is a fourth time, and the method proceeds to a next step when the fourth time reaches a fourth time threshold; and
a third step of turning on the bias power supply of the preamplifier in the power amplifier to restore the normal operation of the power amplifier to keep a normal gain.

Preferably, in addition to the power supply voltage in step (1), a temperature of the radio frequency front-end module is monitored in real time.

Preferably, in step (2), determining whether the power supply voltage and the temperature of the radio frequency front-end module reach set thresholds includes the following substeps:
a first step of determining whether the power supply voltage reaches the first voltage threshold, where the method proceeds to a next step when the power supply voltage is greater than or equal to the first voltage threshold, or otherwise, the method proceeds to a previous step to continue monitoring the power supply voltage and the temperature of the radio frequency front-end module; and
a second step of determining whether the temperature of the radio frequency front-end module reaches a first temperature threshold or a second temperature threshold, where the method proceeds to a next step when the temperature of the radio frequency front-end module is less than or equal to the first temperature threshold or the temperature of the radio frequency front-end module is greater than or equal to the second temperature threshold, or otherwise, the method proceeds to a previous step to continue monitoring the power supply voltage and the temperature of the radio frequency front-end module.

The first temperature threshold is less than the second temperature threshold.

Preferably, in step (2), whether the power supply voltage reaches the first voltage threshold or is between the first voltage threshold and the second voltage threshold is determined. The first voltage threshold is greater than the second voltage threshold.

When the power supply voltage is greater than or equal to the first voltage threshold, or when the second voltage threshold is less than the power supply voltage which is less than the first voltage threshold, the method proceeds to a next step to start counting a time. After a counted time satisfies a time threshold, the radio frequency front-end module enters the overvoltage protection mode to reduce the gain of the power amplifier or turn off the power amplifier.

Preferably, in step (6), whether the power supply voltage reaches the fifth voltage threshold or is between the fourth voltage threshold and the fifth voltage threshold is determined. The fourth voltage threshold is greater than the fifth voltage threshold.

When the power supply voltage is less than or equal to the fifth voltage threshold, or when the fifth voltage threshold is less than the power supply voltage which is less than the fourth voltage threshold, the method proceeds to a next step to start counting a time. After a counted time satisfies the time threshold, the radio frequency front-end module exits the overvoltage protection mode, so that the power amplifier is restored to the low-gain operation or the normal operation.

Preferably, in step (2), whether the power supply voltage reaches the first voltage threshold or is between the first voltage threshold and the second voltage threshold is determined, and whether the temperature of the radio frequency front-end module reaches the first temperature threshold or the second temperature threshold is determined. The first voltage threshold is greater than the second voltage threshold, and the first temperature threshold is less than the second temperature threshold.

When the power supply voltage is greater than or equal to the first voltage threshold, or the second voltage threshold is less than the power supply voltage which is less than the first voltage threshold, and the temperature of the radio frequency front-end module is less than or equal to the first temperature threshold or the temperature of the radio frequency front-end module is greater than or equal to the second temperature threshold, the method proceeds to a next step to start counting a time, and after a counted time satisfies the time threshold, the radio frequency front-end module enters the overvoltage protection mode to reduce the gain of the power amplifier or turn off the power amplifier.

Preferably, after the causing the radio frequency front-end module to enter the overvoltage protection mode in step (5), a voltage clamping circuit is turned on to provide a clamped power supply voltage to the power amplifier, so that the gain of the power amplifier is limited.

After the causing the radio frequency front-end module to exit the overvoltage protection mode in step (9), the voltage clamping circuit is turned off to provide a normal power supply voltage to the power amplifier, so that the power amplifier is restored to normal operation.

Preferably, after the causing the radio frequency front-end module to enter the overvoltage protection mode in step (5), an output voltage of the bias power supply circuit of the power amplifier is adjusted to a low-voltage level to change a direct current operating point of the power amplifier, so that the gain of the power amplifier is reduced.

According to a second aspect of embodiments of the present invention, a radio frequency front-end module having an overvoltage protection function is provided and at least includes a power amplifier, an output matching circuit, and an analog control circuit. The analog control circuit includes at least a voltage monitoring and comparison circuit, a bias power supply circuit, and a logic control circuit.

An output end of the power amplifier is connected to the output matching circuit.

The voltage monitoring and comparison circuit is configured to monitor a power supply voltage, compare the power supply voltage with a set threshold voltage, and generate, when a monitored voltage reaches a voltage threshold, a control signal that is supplied to the logic control circuit.

The bias power supply circuit is configured to provide a power supply to the bias circuit of the power amplifier.

The logic control circuit is configured to perform function control and an adjustment of an electrical parameter on the radio frequency front-end module.

The radio frequency front-end module enters an overvoltage protection mode when the power supply voltage reaches a first voltage threshold, and the analog control circuit reduces a gain of the power amplifier or turns off the power amplifier. The radio frequency front-end module exits the overvoltage protection mode when the power supply voltage reaches a fifth voltage threshold, and the analog control circuit enables the power amplifier to restore low-gain operation or normal operation, to implement overvoltage protection of the radio frequency front-end module.

Preferably, the radio frequency front-end module further includes an attenuation circuit, and the analog control circuit further includes a timer and an attenuation enable control circuit.

The attenuation circuit is connected to an input end of the power amplifier.

The radio frequency front-end module enters the overvoltage protection mode with a delay of a preset time period when the power supply voltage reaches the first voltage threshold, and the attenuation enable control circuit performs control to enable the attenuation circuit to reduce the gain of the power amplifier.

The radio frequency front-end module exits the overvoltage protection mode with the delay of the preset time period when the power supply voltage reaches the fifth voltage threshold, and the attenuation enable control circuit performs control to turn off the attenuation circuit to restore the power amplifier to the normal operation.

Preferably, the analog control circuit further includes a temperature monitoring circuit, configured to monitor a temperature of the radio frequency front-end module and compare the temperature with a set temperature threshold.

The radio frequency front-end module enters the overvoltage protection mode when the power supply voltage reaches the first voltage threshold, and the temperature of the radio frequency front-end module reaches a first temperature threshold or a second temperature threshold, and the analog control circuit reduces the gain of the power amplifier or turns off the power amplifier.

Preferably, the analog control circuit further includes a voltage clamping circuit, and a power supply source supplies power to the power amplifier through the voltage clamping circuit.

The radio frequency front-end module enters the overvoltage protection mode when the power supply voltage reaches the first voltage threshold, and the temperature of the radio frequency front-end module reaches the first temperature threshold or the second temperature threshold, and the voltage clamping circuit limits the power supply voltage of the power amplifier to the first voltage threshold, so that the gain of the power amplifier is limited.

Preferably, after the radio frequency front-end module enters the overvoltage protection mode, in a power amplifier circuit formed by multi-stage power amplifiers, a bias power supply of a preamplifier is turned off, only a final amplifier is kept to operate, and a radio frequency signal is transmitted to the final amplifier through a feedback path, thereby reducing the gain of the power amplifier.

Preferably, after the radio frequency front-end module enters the overvoltage protection mode, an output voltage of the bias power supply circuit is adjusted to a low-voltage level to change a direct current operating point of the power amplifier, thereby reducing the gain of the power amplifier.

Preferably, the attenuation circuit includes a first capacitor, a first transistor, a first resistor, and a second resistor. A collector of the first transistor is connected to a radio frequency signal input end through the first capacitor, and an emitter of the first transistor is connected to a ground potential terminal. Two ends of the first resistor are connected across the collector and a base of the first transistor. An attenuation enabling control signal end is connected to the base of the first transistor through the second resistor.

Preferably, the attenuation circuit is connected to a radio frequency switch branch in parallel, and after the parallel connection, an end of the attenuation circuit is connected to a radio frequency signal input end, and the other end of the attenuation circuit is connected to the input end of the power amplifier. A control end of a radio frequency switch in the radio frequency switch branch is connected to an attenuation enabling control signal end.

According to a third aspect of embodiments of the present invention, an electronic device is provided, including the foregoing radio frequency front-end module having an overvoltage protection function.

Compared with the related art, the overvoltage protection method for a radio frequency front-end module provided in the present invention employs the technical solution in which whether the power supply voltage or the power supply voltage and the temperature of the radio frequency front-end module reach set thresholds, the radio frequency front-end module is controlled to enter or exit the overvoltage protection mode, and related unit circuits are controlled in the overvoltage protection mode, so as to reduce the gain of the power amplifier or turn off the power amplifier. Therefore, the effective protection on the radio frequency front-end module is achieved, thereby reducing a failure probability of a mobile communication system and additionally, improving the service life of the radio frequency front-end module.

### BRIEF DESCRIPTION OF THE DRAWINGS

FIG. 1 is a schematic structural diagram 1 of a radio frequency front-end module according to an embodiment of the present invention;
FIG. 2 is a flowchart of an overvoltage protection method for a radio frequency front-end module according to an embodiment of the present invention;
FIG. 3 is a schematic structural diagram 2 of a radio frequency front-end module according to an embodiment of the present invention;
FIG. 4 is a flowchart of an overvoltage protection method for a radio frequency front-end module according to a first embodiment of the present invention;
FIG. 5 is a flowchart of an overvoltage protection method for a radio frequency front-end module according to a second embodiment of the present invention;
FIG. 6A is a circuit principle diagram of a first solution of an attenuation circuit according to an embodiment of the present invention;
FIG. 6B is a circuit principle diagram of a second solution of an attenuation circuit according to an embodiment of the present invention;
FIG. 7 is a principle diagram of a power amplifier according to an embodiment of the present invention;
FIG. 8 is a flowchart of an overvoltage protection method for a radio frequency front-end module according to a third embodiment of the present invention;
FIG. 9 is a flowchart of an overvoltage protection method for a radio frequency front-end module according to a fourth embodiment of the present invention;
FIG. 10 is a flowchart of an overvoltage protection method for a radio frequency front-end module according to a fifth embodiment of the present invention;
FIG. 11 is a flowchart 1 of an overvoltage protection method for a radio frequency front-end module according to a sixth embodiment of the present invention;
FIG. 12 is a flowchart 2 of an overvoltage protection method for a radio frequency front-end module according to a sixth embodiment of the present invention;
FIG. 13 is a schematic structural diagram 3 of a radio frequency front-end module according to an embodiment of the present invention;
FIG. 14 is a flowchart of an overvoltage protection method for a radio frequency front-end module according to a seventh embodiment of the present invention; and
FIG. 15 is a schematic diagram of an electronic device using the radio frequency front-end module having an overvoltage protection function provided in the present invention.

### DETAILED DESCRIPTION

Technical content of the present invention is described in detail below with reference to the accompanying drawings and specific embodiments.

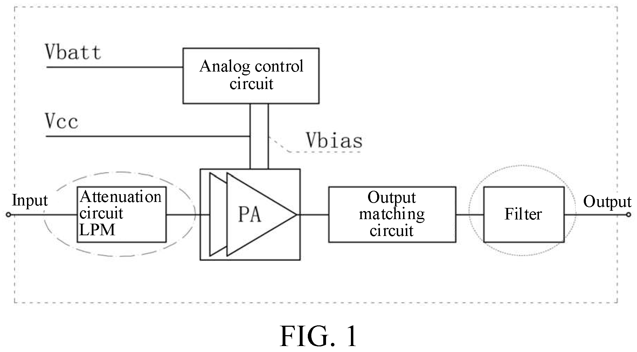

As shown in FIG. 1, a radio frequency front-end module at least includes a power amplifier (PA), an output matching circuit (output matching), and an analog control circuit and may further include an attenuation circuit (LPM) and a filter according to requirements. The attenuation circuit is connected to an input end of the power amplifier, and an output end of the power amplifier is connected to the filter through the output matching circuit. A terminal of a battery voltage Vbatt is connected to the analog control circuit; the output end of the analog control circuit is connected to the power amplifier; and a terminal of a power voltage VCC is connected to the power amplifier and the analog control circuit.

In the radio frequency front-end module, the power amplifier is prone to failure under conditions of high voltage, high power, and high or low temperature, and the filter is prone to failure under high power and high temperature. High-power conditions are generally a high-voltage environment, and the high temperature or the low temperature more easily accelerates the failure of the device. Therefore, the filter needs to be limited to operate in a high-power environment. That is, output power of the power amplifier needs to be limited, and further, the filter needs to be limited to operate in a high-temperature and high-power environment. The maximum output power of the power amplifier is directly related to a power voltage and input power of the power amplifier. Therefore, limiting the power voltage and the input power of the power amplifier is also an important method for improving the reliability of the radio frequency front-end module.

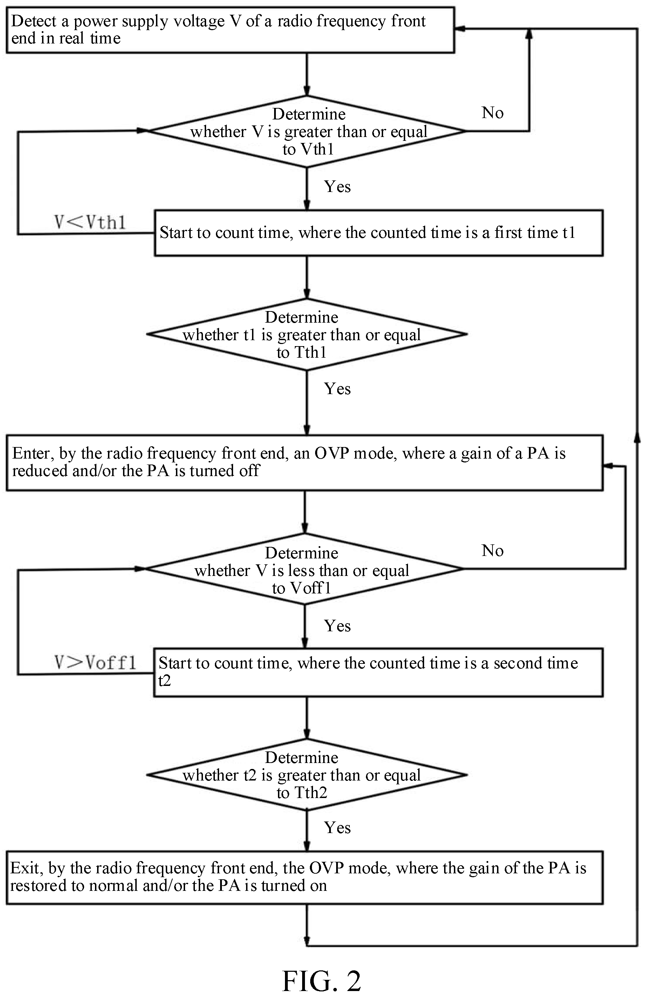

As shown in FIG. 2, the overvoltage protection method for a radio frequency front-end module provided in the present invention includes the following steps:
S1: Monitor a power supply voltage V of the radio frequency front-end module in real time.

The power supply voltage V includes a battery voltage Vbatt and/or a power voltage VCC.

S2: Determine whether the power supply voltage V reaches a first voltage threshold Vth1, where the method proceeds to a next step when V is greater than or equal to Vth1, or otherwise, the method proceeds to a previous step to continue monitoring the power supply voltage.

S3: Start counting a time, where a counted time is a first time t1, and the first time is a duration in which the power supply voltage V is greater than or equal to the first voltage threshold Vth1.

It is to be noted that during time counting, when a monitored power supply voltage V is less than the first voltage threshold Vth1, the time counting is stopped, the first time is zeroed out, and the method proceeds to step S2.

S4: Determine whether the first time t1 reaches a first time threshold Tth1, where the method proceeds to a next step when the t1 is greater than or equal to the Tth1.

S5: Cause the radio frequency front-end module to enter an overvoltage protection (OVP) mode to reduce a gain of a power amplifier or turn off the power amplifier.

S6: Determine whether the power supply voltage V reaches a fifth voltage threshold Voff1, where the method proceeds to a next step when the V is less than or equal to the Voff1, or otherwise, the method proceeds to a previous step to continue the OVP mode.

The first voltage threshold Vth1 is greater than the fifth voltage threshold Voff1.

S7: Start counting a time, where a counted time is a second time t2, and the second time is a duration in which the power supply voltage V is less than or equal to the fifth voltage threshold Voff1.

It is to be noted that during time counting, when a monitored power supply voltage V is greater than the fifth voltage threshold Voff1, the time counting is stopped, the second time is zeroed out, and the method proceeds to step S6.

S8: Determine whether the second time t2 reaches a second time threshold Tth2, where the method proceeds to a next step when the t2 is greater than or equal to the Tth2.

S9: Cause the radio frequency front-end module to exit the OVP protection mode, to restore the power amplifier to low-gain operation or normal operation.

S10: Return to step S1.

Specific steps of the overvoltage protection method for a radio frequency front-end module according to the present invention are described in detail below using a first embodiment to a seventh embodiment. In the accompanying drawings of the embodiments, PA LPM represents an attenuation circuit before a power amplifier, and PA Bias represents a bias circuit of the power amplifier.

### First Embodiment

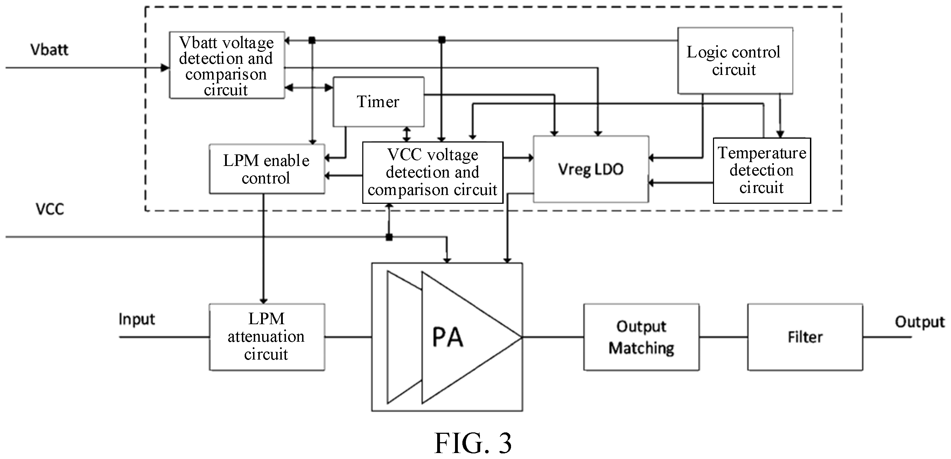

As shown in FIG. 3, in the first embodiment of the present invention, the radio frequency front-end module at least includes a power amplifier (PA), an output matching circuit, a filter, an attenuation circuit (LPM), and an analog control circuit. The attenuation circuit is connected to an input end of the power amplifier, and an output end of the power amplifier is connected to the filter through the output matching circuit. A power supply VCC supplies power to the power amplifier, and a battery power supply Vbatt supplies power to the analog control circuit.

The analog control circuit includes a voltage monitoring and comparison circuit, a timer, an attenuation (LPM) enable control circuit, a bias power supply circuit (Vreg LDO), and a logic control circuit and may further include a temperature monitoring circuit according to requirements. The voltage monitoring and comparison circuit includes a Vbatt voltage monitoring and comparison circuit and/or a VCC voltage monitoring and comparison circuit.

The Vbatt voltage monitoring and comparison circuit is configured to monitor a battery voltage Vbatt, compare the battery voltage with a set threshold voltage, and generate, when a monitored voltage reaches a voltage threshold, a control signal that is supplied to the timer and the logic control circuit.

The VCC voltage monitoring and comparison circuit is configured to monitor a power voltage VCC, compare the power supply voltage with a set threshold voltage, and generate, when a monitored voltage reaches a voltage threshold, a control signal that is supplied to the timer and the logic control circuit.

The timer is configured to count a time. When a counted time reaches a time threshold, a control signal is generated and provided to related unit circuits (including the bias power supply circuit, the VCC voltage monitoring and comparison circuit, the Vbatt voltage monitoring and comparison circuit, and the attenuation enable control circuit).

The attenuation enable control circuit is configured to turn on or turn off the attenuation circuit.

The bias power supply circuit is configured to provide a power supply to a bias circuit of the power amplifier and has an adjustable output voltage. PA Bias On or PA Bias Off is marked in the accompanying drawings of embodiments and is implemented by turning on or turning off an output of the bias power supply circuit.

The temperature monitoring circuit is configured to monitor a temperature of the radio frequency front-end module, compare the temperature with a set temperature threshold, and generate, when a monitored temperature reaches a temperature threshold, a control signal that is provided to related unit circuits (including the bias power supply circuit and the VCC voltage monitoring and comparison circuit).

The logic control circuit is a logic control unit of the entire radio frequency front-end module and is configured to perform function control, an adjustment of electrical parameters, and the like on the radio frequency front-end module.

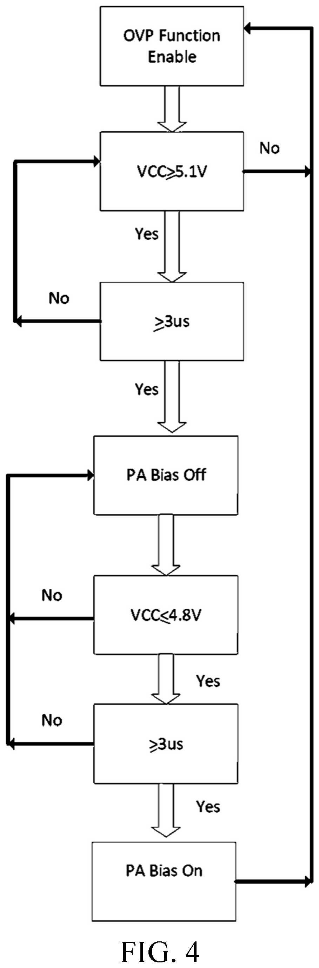

In the first embodiment of the present invention, as shown in FIG. 4, the overvoltage protection method for a radio frequency front-end module provided in the present invention includes the following steps:
S100: Enable an OVP function to be turned on.

Specifically, the OVP function may be selectively turned on or turned off through a logic control circuit.

S101: Monitor a power voltage VCC of the radio frequency front-end module in real time.

S102: Determine whether the power voltage VCC reaches a first voltage threshold Vth1, where the method proceeds to a next step when the VCC is greater than or equal to the Vth1, or otherwise, the method proceeds to a previous step to continue monitoring the power voltage. In this embodiment, the first voltage threshold Vth1 is set to 5.1 V.

S103: Start counting a time, where a counted time is a first time t1, and the first time is a duration in which the power voltage VCC is greater than or equal to the first voltage threshold Vth1.

It is to be noted that during time counting, when a monitored power voltage VCC is less than the first voltage threshold Vth1, the time counting is stopped, the first time is zeroed out, and the method proceeds to step S102.

S104: Determine whether the first time t1 reaches a first time threshold Tth1, where the method proceeds to a next step when the t1 is greater than or equal to the Tth1.

In this embodiment, the first time threshold Tth1 is set to 3 us.

S105: Cause the radio frequency front-end module to enter an OVP protection mode, where the logic control circuit performs control to turn off the output of the bias power supply circuit, and the power amplifier stops operation.

S106: Determine whether the power voltage VCC reaches a fifth voltage threshold Voff1, where the method proceeds to a next step when the VCC is less than or equal to the Voff1, or otherwise, the method proceeds to a previous step to continue the OVP mode. In this embodiment, the fifth voltage threshold Voff1 = Vth1-0.3 V = 4.8 V is set.

S107: Start counting a time, where a counted time is a second time t2, and the second time is a duration in which the power voltage VCC is less than or equal to the fifth voltage threshold Voff1.

It is to be noted that during time counting, when a monitored power voltage VCC is greater than the fifth voltage threshold Voff1, the time counting is stopped, the second time is zeroed out, and the method proceeds to step S106.

S108: Determine whether the second time t2 reaches a second time threshold Tth2, where the method proceeds to a next step when the t2 is greater than or equal to the Tth2.

In this embodiment, the second time threshold Tth2 is set to 3 us.

S109: Cause the radio frequency front-end module to exit the OVP protection mode, where the logic control circuit controls the bias power supply circuit to start output, and the power amplifier is restored to normal operation.

S110: Return to step S101.

It is to be noted that the overvoltage protection method provided in this embodiment is also applicable to monitoring the battery voltage Vbatt to enable the OVP function of the radio frequency front-end module. The voltage thresholds and the time thresholds may be set and changed by the logic control circuit.

### Second Embodiment

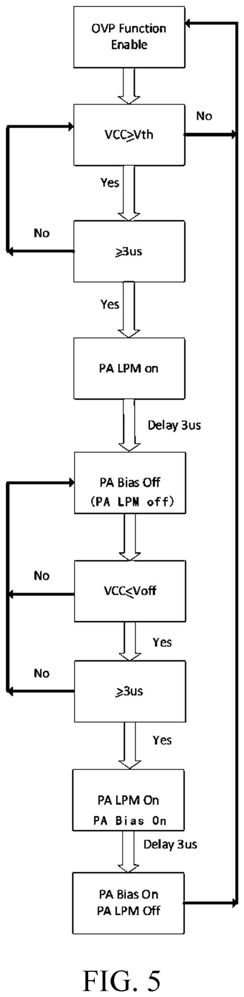

As shown in FIG. 5, in the second embodiment of the present invention, the overvoltage protection method for a radio frequency front-end module provided in the present invention includes the following steps:
S200: Enable an OVP function to be turned on.
S201: Monitor a power voltage VCC of the radio frequency front-end module in real time.
S202: Determine whether the power voltage VCC reaches a first voltage threshold Vth1, where the method proceeds to a next step when the VCC is greater than or equal to the Vth1, or otherwise, the method proceeds to a previous step to continue monitoring the power voltage.
S203: Start counting a time, where a counted time is a first time t1, and the first time is a duration in which the power voltage VCC is greater than or equal to the first voltage threshold Vth1.

It is to be noted that during time counting, when a monitored power voltage VCC is less than the first voltage threshold Vth1, the time counting is stopped, the first time is zeroed out, and the method proceeds to step S202.

S204: Determine whether the first time t1 reaches a first time threshold Tth1, where the method proceeds to a next step when the t1 is greater than or equal to the Tth1.

In this embodiment, the first time threshold Tth1 is set to 3 us.

S205: Cause the radio frequency front-end module to enter an OVP protection mode,
where a first step is enabling, by an attenuation enable control circuit, an attenuation circuit to reduce a gain of the power amplifier.

A second step is starting timing, wherein a counted time is a third time t3, and the method proceeds to a next step when the third time t3 reaches a third time threshold Tth3. In this embodiment, the third time threshold Tth3 is set to 3 us.

A third step is controlling, by the logic control circuit, the bias power supply circuit to turn off output to stop operation of the power amplifier. It is to be noted that after the power amplifier stops operation, the attenuation circuit is also turned off.

S206: Determine whether the power voltage VCC reaches a fifth voltage threshold Voff1, where the method proceeds to a next step when the VCC is less than or equal to the Voff1, or otherwise, the method proceeds to a previous step to continue the OVP mode. In this embodiment, the fifth voltage threshold Voff1 is set to Vth1 minus 0.3 V.

S207: Start counting a time, where a counted time is a second time t2, and the second time is a duration in which the power voltage VCC is less than or equal to the fifth voltage threshold Voff1.

It is to be noted that during time counting, when a monitored power voltage VCC is greater than the fifth voltage threshold Voff1, the time counting is stopped, the second time is zeroed out, and the method proceeds to step S206.

S208: Determine whether the second time t2 reaches a second time threshold Tth2, where the method proceeds to a next step when the t2 is greater than or equal to the Tth2.

In this embodiment, the second time threshold Tth2 is set to 3 us.

S209: Cause the radio frequency front-end module to exit the OVP protection mode, where
a first step is controlling, by the logic control circuit, the bias power supply circuit to start output to restore operation of the power amplifier, and an attenuation enable control circuit enables an attenuation circuit to reduce a gain of the power amplifier.

A second step is starting timing, wherein a counted time is a fourth time t4, and the method proceeds to a next step when the fourth time t4 reaches a fourth time threshold Tth4. In this embodiment, the fourth time threshold Tth4 is set to 3 us.

A third step is turning off, by the attenuation enable control circuit, the attenuation circuit to restore the normal operation of the power amplifier to keep a normal gain.

S210: Return to step S201.

In a first step of step S205 of this embodiment, the radio frequency front-end module enters the OVP protection mode, and the attenuation enable control circuit starts the attenuation circuit, so that the gain of the power amplifier is reduced. For an implementation in which the attenuation enable control circuit controls the attenuation circuit, the following two technical solutions are provided.

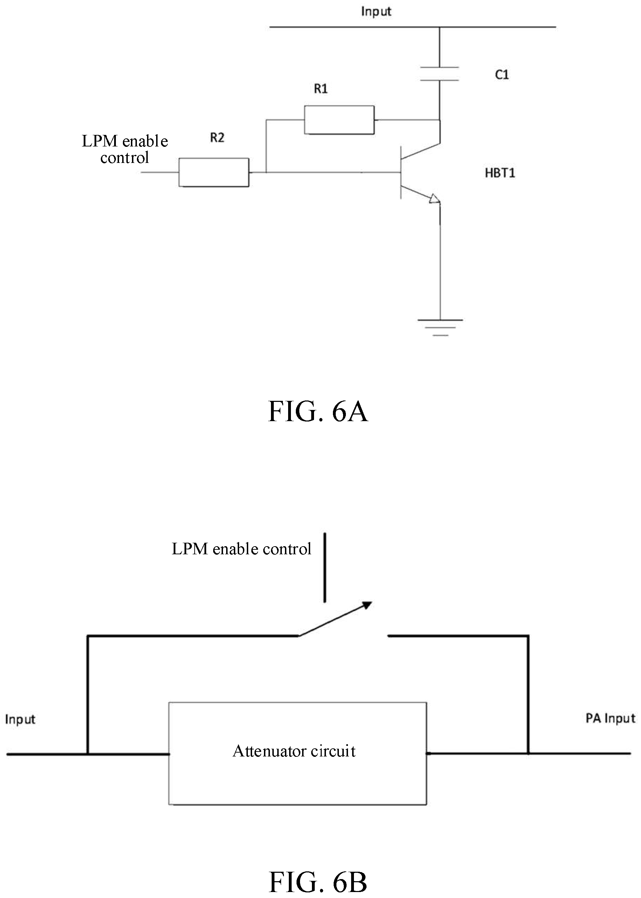

A first solution is shown in FIG. 6A. The attenuation circuit includes a first capacitor C1, a first transistor HBT1, a first resistor R1, and a second resistor R2. A collector of the first transistor HBT1 is connected to a radio frequency signal input end Input through the first capacitor C1, and an emitter of the first transistor HBT1 is connected to a ground potential terminal. Two ends of the first resistor R1 are connected across the collector and a base of the first transistor HBT1. An attenuation (LPM) enabling control signal end is connected to the base of the first transistor HBT1 through the second resistor R2.

When the attenuation enabling control signal is at a high level, the first transistor HBT1 is turned on, and a radio frequency signal inputted from the radio frequency signal input end Input is attenuated through the ground by the first capacitor C1, thereby reducing the gain of the power amplifier. When the attenuation enabling control signal is at a low level, the first transistor HBT1 is turned off, the radio frequency signal enters the power amplifier, and the power amplifier maintains a normal gain.

A second solution is shown in FIG. 6B. The attenuation circuit is connected to the radio frequency switch branch in parallel, and after the parallel connection, an end of the attenuation circuit is connected to the radio frequency signal input end Input, and the other end of the attenuation circuit is connected to the input end of the power amplifier PA Input; and a control end of a radio frequency switch in the radio frequency switch branch is connected to an attenuation (LPM) enabling control signal end. The attenuation circuit is usually formed by a passive element such as an RLC.

When the attenuation enabling control signal is at a high level, the radio frequency switch is turned on, that is, the radio frequency switch branch is open, and the radio frequency signal inputted from the radio frequency signal input end Input enters the power amplifier through the attenuation circuit, thereby reducing the gain of the power amplifier. When the attenuation enabling control signal is at a low level, the radio frequency switch is turned off, that is, the radio frequency switch branch is turned on, the radio frequency signal enters the power amplifier, and the power amplifier maintains a normal gain.

In the first step of step S205 of this embodiment, a technical solution in which the radio frequency front-end module enters the OVP protection mode to reduce the gain of the power amplifier may also be implemented by adjusting an output voltage of a bias power supply circuit of the power amplifier to a low-voltage level to change a direct current operating point of the power amplifier and thus to achieve a reduction in the gain of the power amplifier. Alternatively, enabling the attenuation circuit and reducing the bias voltage of the power amplifier are both used.

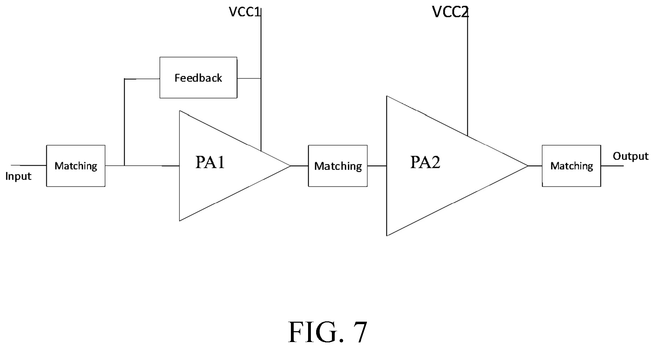

In addition, as shown in FIG. 7, in a power amplifier circuit formed by multi-stage power amplifiers, a technical solution in which a bias power supply of a preamplifier PA1 is turned off, only a final amplifier PA2 is kept to operate, and a radio frequency signal is transmitted to the final amplifier through a feedback path may also be used to reduce the gain of the power amplifier.

### Third Embodiment

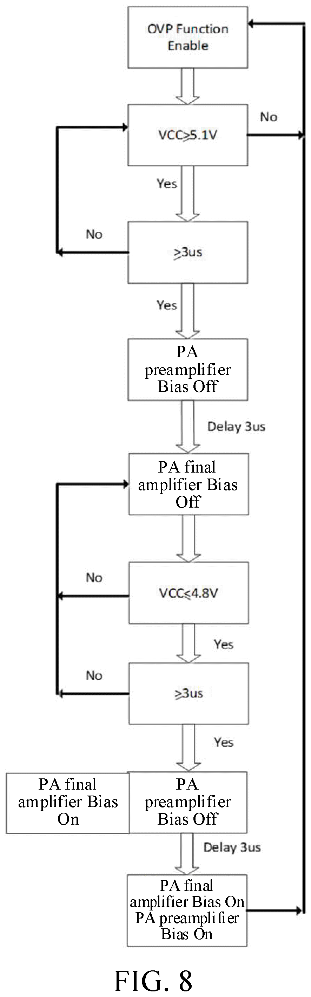

As shown in FIG. 8, in the third embodiment of the present invention, the overvoltage protection method for a radio frequency front-end module provided in the present invention includes the following steps:
S300: Enable an OVP function to be turned on.
S301: Monitor a power voltage VCC of the radio frequency front-end module in real time.
S302: Determine whether the power voltage VCC reaches a first voltage threshold Vth1, where the method proceeds to a next step when the VCC is greater than or equal to the Vth1, or otherwise, the method proceeds to a previous step to continue monitoring the power voltage. In this embodiment, the first voltage threshold Vth1 is set to 5.1 V.
S303: Start counting a time, where a counted time is a first time t1, and the first time is a duration in which the power voltage VCC is greater than or equal to the first voltage threshold Vth1.

It is to be noted that during time counting, when a monitored power voltage VCC is less than the first voltage threshold Vth1, the time counting is stopped, the first time is zeroed out, and the method proceeds to step S302.

S304: Determine whether the first time t1 reaches the first time threshold Tth1, where the method proceeds to a next step when the t1 is greater than or equal to the Tth1.

In this embodiment, the first time threshold Tth1 is set to 3 us.

S305: Cause the radio frequency front-end module to enter an OVP protection mode, where
a first step is turning off a bias power supply of a preamplifier in the power amplifier to reduce the gain of the power amplifier. The preamplifier may include amplifiers before the final amplifier.

A second step is starting timing, wherein a counted time is a third time t3, and the method proceeds to a next step when the third time t3 reaches a third time threshold Tth3. In this embodiment, the third time threshold Tth3 is set to 3 us.

A third step is turning off a bias power supply of the final amplifier in the power amplifier to stop operation of the power amplifier.

S306: Determine whether the power voltage VCC reaches a fifth voltage threshold Voff1, where the method proceeds to a next step when the VCC is less than or equal to the Voff1, or otherwise, the method proceeds to a previous step to continue the OVP mode. In this embodiment, the fifth voltage threshold Voff1 = Vth1-0.3 V = 4.8 V is set.

S307: Start counting a time, where a counted time is a second time t2, and the second time is a duration in which the power voltage VCC is less than or equal to the fifth voltage threshold Voff1.

It is to be noted that during time counting, when a monitored power voltage VCC is greater than the fifth voltage threshold Voff1, the time counting is stopped, the second time is zeroed out, and the method proceeds to step S306.

S308: Determine whether the second time t2 reaches a second time threshold Tth2, where the method proceeds to a next step when the t2 is greater than or equal to the Tth2.

In this embodiment, the second time threshold Tth2 is set to 3 us.

S309: Cause the radio frequency front-end module to exit the OVP protection mode,
a first step is turning on the bias power supply of the final amplifier in the power amplifier to restore the low-gain operation of the power amplifier. In this case, the bias power supply of the preamplifier is turned off, and the gain of the power amplifier is reduced.

A second step is starting timing, wherein a counted time is a fourth time t4, and the method proceeds to a next step when the fourth time t4 reaches a fourth time threshold Tth4. In this embodiment, the fourth time threshold Tth4 is set to 3 us.

A third step is turning on the bias power supply of the preamplifier in the power amplifier to restore the normal operation of the power amplifier to keep a normal gain.

S310: Return to step S301.

In this embodiment, after the radio frequency front-end module enters the OVP protection mode, reducing the gain of the power amplifier and turning off the power amplifier with a delay are implemented by hierarchically turning off a previous stage and a final stage of the power amplifier.

### Fourth Embodiment

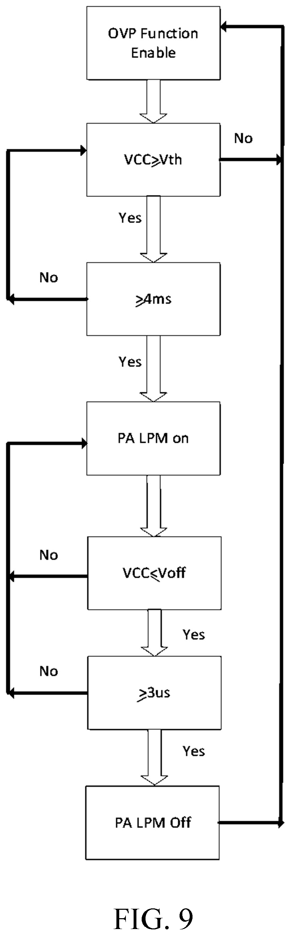

As shown in FIG. 9, in the fourth embodiment of the present invention, the overvoltage protection method for a radio frequency front-end module provided in the present invention includes the following steps:
S400: Enable an OVP function to be turned on.
S401: Monitor a power voltage VCC of the radio frequency front-end module in real time.
S402: Determine whether the power voltage VCC reaches a first voltage threshold Vth1, where the method proceeds to a next step when the VCC is greater than or equal to the Vth1, or otherwise, the method proceeds to a previous step to continue monitoring the power voltage.
S403: Start counting a time, where a counted time is a first time t1, and the first time is a duration in which the power voltage VCC is greater than or equal to the first voltage threshold Vth1.

It is to be noted that during time counting, when a monitored power voltage VCC is less than the first voltage threshold Vth1, the time counting is stopped, the first time is zeroed out, and the method proceeds to step S402.

S404: Determine whether the first time t1 reaches a first time threshold Tth1, where the method proceeds to a next step when the t1 is greater than or equal to the Tth1.

In this embodiment, the first time threshold Tth1 is set to 4 ms.

S405: Cause the radio frequency front-end module to enter an OVP protection mode, where an attenuation enable control circuit enables an attenuation circuit to reduce a gain of the power amplifier.

S406: Determine whether the power voltage VCC reaches a fifth voltage threshold Voff1, where the method proceeds to a next step when the VCC is less than or equal to the Voff1, or otherwise, the method proceeds to a previous step to continue the OVP mode. In this embodiment, the fifth voltage threshold Voff1 is set to Vth1 minus 0.3 V.

S407: Start counting a time, where a counted time is a second time t2, and the second time is a duration in which the power voltage VCC is less than or equal to the fifth voltage threshold Voff1.

It is to be noted that during time counting, when a monitored power voltage VCC is greater than the fifth voltage threshold Voff1, the time counting is stopped, the second time is zeroed out, and the method proceeds to step S406.

S408: Determine whether the second time t2 reaches a second time threshold Tth2, where the method proceeds to a next step when the t2 is greater than or equal to the Tth2.

In this embodiment, the second time threshold Tth2 is set to 3 us.

S409: Cause the radio frequency front-end module to exit the OVP protection mode, where the attenuation enable control circuit turns off the attenuation circuit to restore the normal operation of the power amplifier.

S410: Return to step S401.

In step S405 of this embodiment, the radio frequency front-end module enters the OVP protection mode. A technical solution in which the gain of the power amplifier is reduced may also be implemented by adjusting an output voltage of a bias power supply circuit of the power amplifier to a low-voltage level to change a direct current operating point of the power amplifier and thus to achieve a reduction in the gain of the power amplifier. Alternatively, a technical solution in which enabling the attenuation circuit and reducing the bias voltage of the power amplifier are both used may be employed. In addition, in a power amplifier circuit formed by multi-stage power amplifiers, a technical solution in which a bias power supply of a preamplifier is turned off, only a final amplifier is kept to operate, and a radio frequency signal is transmitted to the final amplifier through a feedback path may also be used, to reduce the gain of the power amplifier.

### Fifth Embodiment

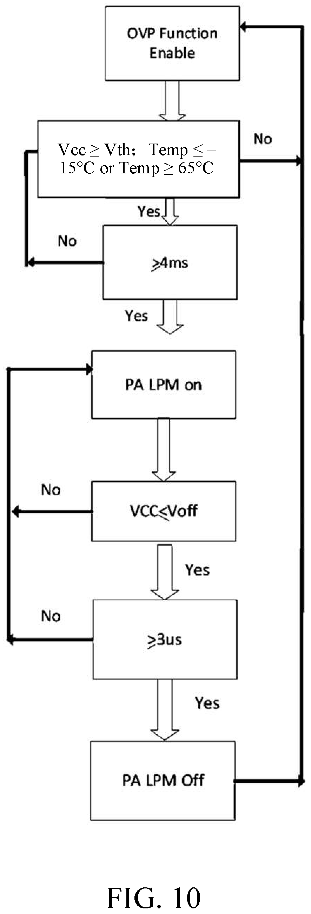

As shown in FIG. 10, in a fifth embodiment of the present invention, in the overvoltage protection method for a radio frequency front-end module provided in the present invention, monitoring and determination of a temperature of the radio frequency front-end module are further included in a condition for determining that a radio frequency front-end module enters an OVP protection mode. Specifically, the following steps are included:
S500: Enable an OVP function to be turned on.
S501: Monitor a power voltage VCC of the radio frequency front-end module in real time, where a temperature Temp of the radio frequency front-end module is monitored in real time.
S502: Determine a power voltage and the temperature of the radio frequency front-end module

A first step is determining whether the power voltage VCC reaches a first voltage threshold Vth1, where the method proceeds to a next step when the VCC is greater than or equal to the Vth1, or otherwise, the method proceeds to a previous step to continue monitoring the power voltage and the temperature of the radio frequency front-end module.

A second step is determining whether the temperature Temp of the radio frequency front-end module reaches a first temperature threshold Teth1 or a second temperature threshold Teth2, where the method proceeds to a next step when the Temp is less than or equal to the Teth1 or the Temp is greater than or equal to the Teth2, or otherwise, the method proceeds to a previous step to continue monitoring the power voltage and the temperature of the radio frequency front-end module.

The first temperature threshold Teth1 is less than the second temperature threshold Teth2. In this embodiment, the first temperature threshold Teth1 is set to -15°C and the second temperature threshold Teth2 is set to 65°C.

S503: Start counting a time, where a counted time is a first time t1, and the first time is a duration in which the power voltage and the temperature of the radio frequency front-end module both satisfy set thresholds.

It is to be noted that during the time counting, when a monitored power voltage and/or the temperature of the radio frequency front-end module does not satisfy the set threshold, the time counting is stopped, the first time is zeroed out, and the method proceeds to step S502.

S504: Determine whether the first time t1 reaches a first time threshold Tth1, where the method proceeds to a next step when the t1 is greater than or equal to the Tth1.

In this embodiment, the first time threshold Tth1 is set to 4 ms.

S505: Cause the radio frequency front-end module to enter an OVP protection mode, where an attenuation enable control circuit enables an attenuation circuit to reduce a gain of the power amplifier.

S506: Determine whether the power voltage VCC reaches a fifth voltage threshold Voff1, where the method proceeds to a next step when the VCC is less than or equal to the Voff1, or otherwise, the method proceeds to a previous step to continue the OVP mode. In this embodiment, the fifth voltage threshold Voff1 is set to Vth1 minus 0.3 V.

S507: Start counting a time, where a counted time is a second time t2, and the second time is a duration in which the power voltage VCC is less than or equal to the fifth voltage threshold Voff1.

It is to be noted that during time counting, when a monitored power voltage VCC is greater than the fifth voltage threshold Voff1, the time counting is stopped, the second time is zeroed out, and the method proceeds to step S506.

S508: Determine whether the second time t2 reaches a second time threshold Tth2, where the method proceeds to a next step when the t2 is greater than or equal to the Tth2.

In this embodiment, the second time threshold Tth2 is set to 3 us.

S509: Cause the radio frequency front-end module to exit the OVP protection mode, where the attenuation enable control circuit turns off the attenuation circuit to restore the normal operation of the power amplifier.

S510: Return to step S501.

In step S505 of this embodiment, the technical solution in which the radio frequency front-end module enters the OVP protection mode to reduce the gain of the power amplifier may also be another technical solution in the fourth embodiment. Details are not described herein again.

### Sixth Embodiment

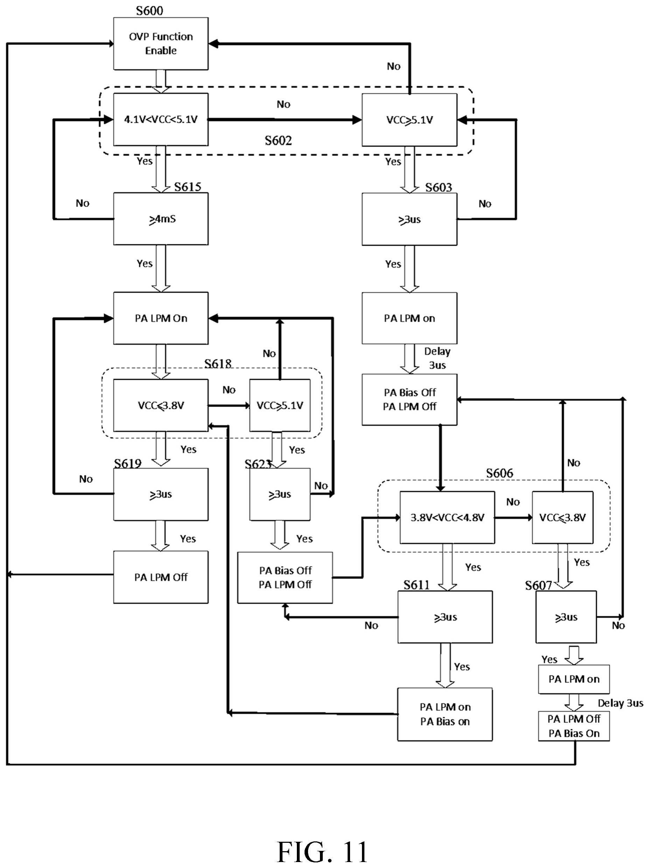

As shown in FIG. 11, in the sixth embodiment of the present invention, in the overvoltage protection method for a radio frequency front-end module provided in the present invention, for both voltage monitoring and determination before an OVP protection mode is entered and before the OVP protection mode is exited, a segment voltage threshold is used for determination. After the OVP protection mode is entered and after the OVP protection mode is exited, an analog control circuit uses different control manners to reduce the gain of the power amplifier or turn off the power amplifier, or restore the low-gain operation or normal operation of the power amplifier. Specifically, the following steps are included:
S600: Enable an OVP function to be turned on.
S601: Monitor a power voltage VCC of the radio frequency front-end module in real time.
S602: Determine whether the power voltage VCC reaches the first voltage threshold Vth1 or is between the first voltage threshold Vth1 and the second voltage threshold Vth2, where the method proceeds to a next step when the VCC is greater than or equal to the Vth1, and the method proceeds to step S615 when the Vth2 is less than the VCC which is less than the Vth1, or otherwise, the method proceeds to a previous step to continue monitoring the power voltage. The first voltage threshold Vth1 is greater than the second voltage threshold Vth2. In this embodiment, the first voltage threshold Vth1 is set to 5.1 V and the second voltage threshold Vth2 is set to 4.1 V.
S603: Start counting a time, where a counted time is a first time t1, and the first time is a duration in which the power voltage VCC is greater than or equal to the first voltage threshold Vth1.

It is to be noted that during time counting, when a monitored power voltage VCC is less than the first voltage threshold Vth1, the time counting is stopped, the first time is zeroed out, and the method proceeds to step S602.

S604: Determine whether the first time t1 reaches a first time threshold Tth1, where the method proceeds to a next step when the t1 is greater than or equal to the Tth1.

In this embodiment, the first time threshold Tth1 is set to 3 us.

S605: Cause the radio frequency front-end module to enter an OVP protection mode, where
a first step is enabling, by an attenuation enable control circuit, an attenuation circuit to reduce a gain of the power amplifier.

A second step is starting timing, wherein a counted time is a third time t3, and the method proceeds to a next step when the third time t3 reaches a third time threshold Tth3. In this embodiment, the third time threshold Tth3 is set to 3 us.

A third step is controlling, by the logic control circuit, the bias power supply circuit to turn off output to stop operation of the power amplifier. It is to be noted that after the power amplifier stops operation, the attenuation circuit is also turned off.

S606: Determine whether the power voltage VCC reaches a fifth voltage threshold Voff1 or is between a fourth voltage threshold Voff2 and the fifth voltage threshold Voff1, where the method proceeds to a next step when the VCC is less than or equal to the Voff1, and the method proceeds to step S611 when the Voff1 is less than the VCC which is less than the Voff2, or otherwise, the method proceeds to a previous step to continue the OVP mode. The fourth voltage threshold Voff2 is greater than the fifth voltage threshold Voff1. In this embodiment, the fifth voltage threshold Voff1 is set to 3.8 V and the fourth voltage threshold Voff2 is set to 4.8 V.

S607: Start counting a time, where a counted time is a second time t2, and the second time is a duration in which the power voltage VCC is less than or equal to the fifth voltage threshold Voff1.

It is to be noted that during time counting, when a monitored power voltage VCC is greater than the fifth voltage threshold Voff1, the time counting is stopped, the second time is zeroed out, and the method proceeds to step S606.

S608: Determine whether the second time t2 reaches a second time threshold Tth2, where the method proceeds to a next step when the t2 is greater than or equal to the Tth2.

In this embodiment, the second time threshold Tth2 is set to 3 us.

S609: Cause the radio frequency front-end module to exit the OVP protection mode, where
a first step is controlling, by the logic control circuit, the bias power supply circuit to start output to restore operation of the power amplifier, and an attenuation enable control circuit enables an attenuation circuit to reduce a gain of the power amplifier.

A second step is starting timing, wherein a counted time is a fourth time t4, and the method proceeds to a next step when the fourth time t4 reaches a fourth time threshold Tth4. In this embodiment, the fourth time threshold Tth4 is set to 3 us.

A third step is turning off, by the attenuation enable control circuit, the attenuation circuit to restore the normal operation of the power amplifier to keep a normal gain.

S610: Return to step S601.

S611: Start counting a time, where a counted time is a sixth time t6, and the sixth time is a duration in which the power voltage VCC is between the fourth voltage threshold Voff2 and the fifth voltage threshold Voff1.

It is to be noted that in a timing process, when the monitored power voltage VCC does not satisfy Voff1 < VCC < Voff2, the time counting is stopped, the sixth time is zeroed out, and the method proceeds to step S606.

S612: Determine whether the sixth time t6 reaches a sixth time threshold Tth6, where the method proceeds to a next step when the t6 is greater than or equal to the Tth6. In this embodiment, the sixth time threshold Tth6 is set to 3 us.

S613: Continue the OVP protection mode, where the logic control circuit controls the bias power supply circuit to start output to restore operation of the power amplifier; and an attenuation enable control circuit enables an attenuation circuit to reduce a gain of the power amplifier.

S614: The method proceeds to step S618.

S615: Start counting a time, where a counted time is a fifth time t5, and the fifth time is a duration in which the power voltage VCC is between the first voltage threshold Vth1 and the second voltage threshold Vth2.

It is to be noted that in a timing process, when the monitored power voltage VCC does not satisfy Vth2 < VCC < Vth1, the time counting is stopped, the fifth time is zeroed out, and the method proceeds to step S602.

S616: Determine whether the fifth time t5 reaches a fifth time threshold Tth5, where the method proceeds to a next step when the t5 is greater than or equal to the Tth5. In this embodiment, the fifth time threshold Tth5 is set to 4 ms.

S617: Cause the radio frequency front-end module to enter an OVP protection mode, where an attenuation enable control circuit enables an attenuation circuit to reduce a gain of the power amplifier.

S618: Determine whether the power voltage VCC reaches the fifth voltage threshold Voff1 or the first voltage threshold Vth1, where the method proceeds to a next step when the VCC is less than or equal to the Voff1, the method proceeds to step S623 when the VCC is greater than or equal to the Vth1, or otherwise, the method proceeds to the previous step S613 to continue the OVP protection mode.

S619: Start counting a time, where a counted time is an eighth time t8, and the eighth time is a duration in which the power voltage VCC is less than or equal to the fifth voltage threshold Voff1.

It is to be noted that in a timing process, when the monitored power voltage VCC is greater than the fifth voltage threshold Voff1, the timing is stopped, the eighth time is zeroed out, and the method proceeds to step S613.

S620: Determine whether the eighth time t8 reaches an eighth time threshold Tth8, where the method proceeds to a next step when the t8 is greater than or equal to the Tth8. In this embodiment, the eighth time threshold Tth8 is set to 3 us.

S621: Cause the radio frequency front-end module to exit the OVP protection mode, where the attenuation enable control circuit turns off the attenuation circuit to restore the gain of the power amplifier to normal.

S622: Return to step S601.

S623: Start counting a time, where a counted time is a tenth time t10, and the tenth time is a duration in which the power voltage VCC is greater than or equal to the first voltage threshold Vth1.

It is to be noted that during time counting, when a monitored power voltage VCC is less than the first voltage threshold Vth1, the time counting is stopped, the first time is zeroed out, and the method proceeds to step S613.

S624: Determine whether the tenth time t10 reaches a tenth time threshold Tth10, where the method proceeds to a next step when the t10 is greater than or equal to the Tth10. In this embodiment, the tenth time threshold Tth10 is set to 3 us.

S625: Cause the radio frequency front-end module to enter an OVP protection mode, where the logic control circuit performs control to turn off the output of the bias power supply circuit, and the power amplifier stops operation. In this case, after the power amplifier stops operation, the attenuation circuit is also turned off.

S626: The method proceeds to step S606.

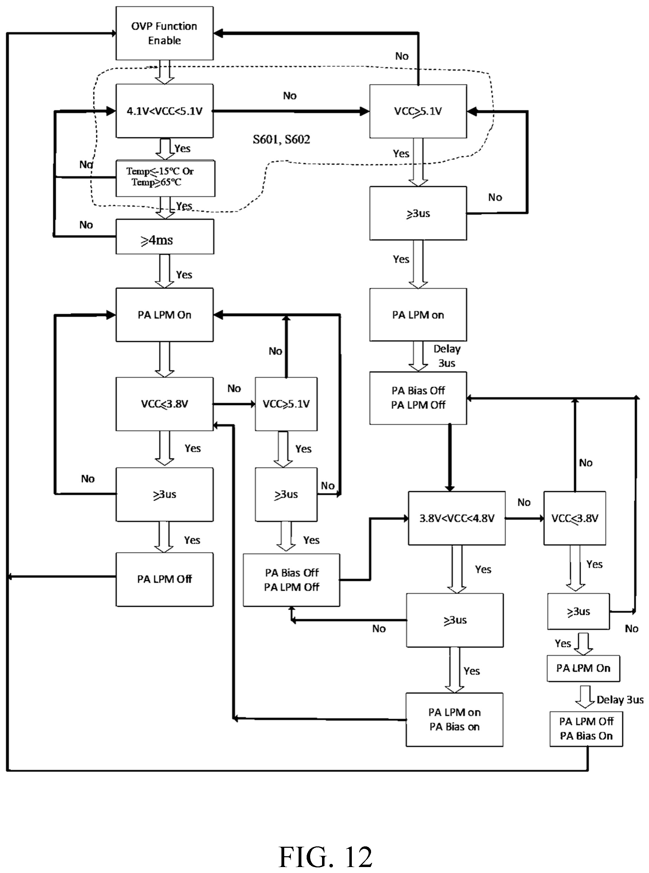

In this embodiment, for voltage monitoring before the OVP protection mode is entered, a segment voltage threshold is used for determination and processing. In another embodiment of the present invention, as shown in FIG. 12, monitoring and determination of a temperature of the radio frequency front-end module may further be performed as a condition for entering the OVP protection mode, and steps S601 and S602 may be implemented in the following manner:
S601: Monitor a power voltage VCC of the radio frequency front-end module in real time, where a temperature Temp of the radio frequency front-end module is monitored in real time.
S602: Determine whether the power voltage VCC reaches the first voltage threshold Vth1 or is between the first voltage threshold Vth1 and the second voltage threshold Vth2, and determine whether the temperature Temp of the radio frequency front-end module reaches a first temperature threshold Teth1 or a second temperature threshold Teth2, where the method proceeds to a next step when the VCC is greater than or equal to the Vth1, and the method proceeds to step S615 when Vth2 < VCC < Vth1, and Temp ≤ Teth1 or Temp ≥ Teth2, or otherwise, the method proceeds to a previous step to continue monitoring the power voltage and the temperature of the radio frequency front-end module. The first temperature threshold Teth1 is less than the second temperature threshold Teth2.

### Seventh embodiment

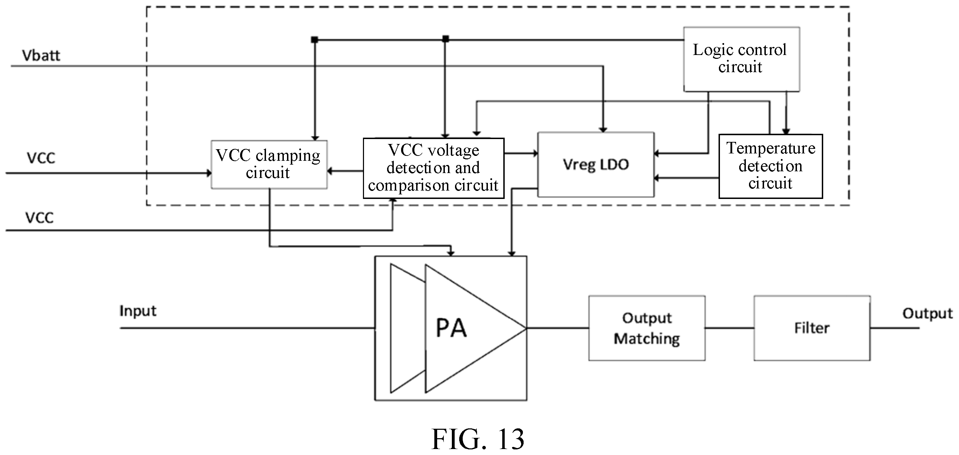

As shown in FIG. 13, in the seventh embodiment of the present invention, the radio frequency front-end module at least includes a power amplifier (PA), an output matching circuit (output matching), a filter (filter), and an analog control circuit. An output end of the power amplifier is connected to the filter through an output matching circuit. The battery power supply Vbatt supplies power to the analog control circuit.

The analog control circuit includes a voltage monitoring and comparison circuit, a temperature monitoring circuit, a voltage clamping circuit, a bias power supply circuit (Vreg LDO), and a logic control circuit. The voltage monitoring and comparison circuit may be a Vbatt voltage monitoring and comparison circuit or a VCC voltage monitoring and comparison circuit, and the voltage clamping circuit may be a Vbatt voltage clamping circuit or a VCC voltage clamping circuit. In this embodiment, the VCC voltage monitoring and comparison circuit and the VCC voltage clamping circuit are used as examples for description. The power supply VCC supplies power to the power amplifier through the VCC voltage clamping circuit.

When a function of the VCC voltage clamping circuit is enabled, and when the power voltage VCC is greater than a preset clamping voltage, an output voltage of the VCC voltage clamping circuit is equal to the clamping voltage. When the power voltage VCC is less than the preset clamping voltage, the output voltage of the VCC voltage clamping circuit is equal to the power voltage VCC. When the function of the VCC voltage clamping circuit is disabled, the output voltage of the VCC voltage clamping circuit is always equal to the power voltage VCC.

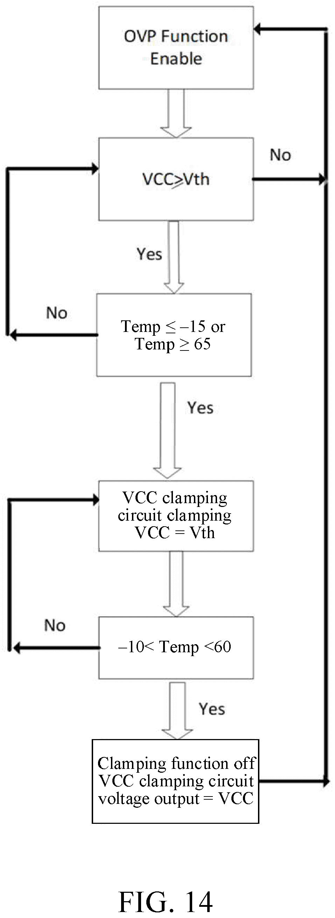

In the seventh embodiment of the present invention, the preset clamping voltage of the VCC voltage clamping circuit is represented by using a first voltage threshold Vth1. As shown in FIG. 14, the overvoltage protection method for a radio frequency front-end module provided in the present invention includes the following steps:
S700: Enable an OVP function to be turned on.
S701: Monitor the power voltage VCC of the radio frequency front-end module in real time, and monitor a temperature Temp of the radio frequency front-end module in real time.
S702: Determine whether the power voltage VCC reaches the first voltage threshold Vth1, and determine whether the temperature Temp of the radio frequency front-end module reaches the first temperature threshold Teth1 or a second temperature threshold Teth2, where the method proceeds to a next step when the VCC is greater than or equal to the Vth1, and the Temp is less than or equal to the Teth1 or the Temp is greater than or equal to the Teth2, or otherwise, the method proceeds to a previous step to continue monitoring the power voltage and the temperature of the radio frequency front-end module. The first temperature threshold Teth1 is less than the second temperature threshold Teth2. In this embodiment, the first temperature threshold Teth1 is set to -15°C and the second temperature threshold Teth2 is set to 65°C.
S703: Cause the radio frequency front-end module to enter an OVP protection mode, where the VCC voltage clamping circuit is turned on to provide a clamped power supply voltage to the power amplifier to limit the gain of the power amplifier.
S704: Determine whether the temperature Temp of the radio frequency front-end module is between a third temperature threshold Teth3 and a fourth temperature threshold Teth4 (that is, a normal temperature range), where the method proceeds to a next step when Teth3 < Temp < Teth4, or otherwise, the method proceeds to a previous step to continue the OVP mode. The third temperature threshold Teth3 is less than the fourth temperature threshold Teth4. In this embodiment, the third temperature threshold Teth3 is set to -10°C and the fourth temperature threshold Teth4 is set to 60°C.
S705: Cause the radio frequency front-end module to exit the OVP protection mode, where the VCC voltage clamping circuit is turned off to provide a power supply voltage VCC to the power amplifier, and the power amplifier is restored to normal operation.
S706: Return to step S701.

The specific steps of the overvoltage protection method for a radio frequency front-end module provided in the present invention are described in detail above through multiple specific embodiments. It is to be noted that the technical solution of enabling the OVP function of the radio frequency front-end module by monitoring the power voltage VCC in the embodiments is also applicable to enabling the OVP function of the radio frequency front-end module by monitoring the battery voltage Vbatt. The voltage thresholds, the time thresholds, and the temperature thresholds in the specific embodiments may be set and changed through the logic control circuit.

Based on the foregoing overvoltage protection method for a radio frequency front-end module, embodiments of the present invention further provide a radio frequency front-end module having an overvoltage protection function. The radio frequency front-end module at least includes a power amplifier, an output matching circuit, and an analog control circuit and may further include an attenuation circuit and a filter according to requirements. An output end of the power amplifier is connected to the filter through an output matching circuit. The attenuation circuit is connected to an input end of the power amplifier. The power supply source includes a battery Vbatt and/or a power supply VCC.

The analog control circuit at least includes a voltage monitoring and comparison circuit, a bias power supply circuit, and a logic control circuit and may further include a timer, an attenuation enable control circuit, a temperature monitoring circuit, and a voltage clamping circuit according to requirements. The voltage monitoring and comparison circuit includes a Vbatt voltage monitoring and comparison circuit and/or a VCC voltage monitoring and comparison circuit.

The voltage monitoring and comparison circuit is configured to monitor a power supply voltage, compare the power supply voltage with a set threshold voltage, and generate, when a monitored voltage reaches a voltage threshold, a control signal that is supplied to the logic control circuit. The bias power supply circuit is configured to provide a power supply to a bias circuit of the power amplifier and has an adjustable output voltage. The logic control circuit is a logic control unit of the entire radio frequency front-end module and is configured to perform function control, an adjustment of electrical parameters, and the like on the radio frequency front-end module.

The radio frequency front-end module enters the OVP protection mode, or the radio frequency front-end module enters the OVP protection mode after a preset time period is delayed when the power supply voltage reaches a first voltage threshold Vth1, or the power supply voltage reaches the first voltage threshold Vth1, and the temperature Temp of the radio frequency front-end module reaches a first temperature threshold Teth1 or the second temperature threshold Teth2. The analog control circuit controls a corresponding unit circuit, so that the gain of the power amplifier is reduced or the power amplifier is turned off.

When the power supply voltage reaches a fifth voltage threshold Voff1 or the temperature Temp of the radio frequency front-end module is between the third temperature threshold Teth3 and the fourth temperature threshold Teth4 (that is, a normal temperature range), the radio frequency front-end module exits the OVP protection mode, or the radio frequency front-end module exits the OVP protection mode after a preset time period is delayed. The analog control circuit controls a corresponding unit circuit to enable the power amplifier to restore low-gain operation or normal operation. Therefore, overvoltage protection for the radio frequency front-end module is implemented.

After the radio frequency front-end module enters the OVP protection mode, one or two of the following solutions may be used as a technical solution for reducing a gain of a power amplifier, or another technical solution may be used to reduce the gain of the power amplifier. This is not limited in the present invention.
1. An attenuation enable control circuit is used to enable an attenuation circuit, and a radio frequency signal inputted from a radio frequency signal input end Input enters a power amplifier through the attenuation circuit, thereby reducing a gain of a power amplifier.
2. An output voltage of a bias power supply circuit of the power amplifier is adjusted to a low-voltage level to change a direct current operating point of the power amplifier and thus to achieve a reduction in a gain of a power amplifier.
3. In a power amplifier circuit formed by multi-stage power amplifiers, a bias power supply of a preamplifier is turned off, only a final amplifier is kept to operate, and a radio frequency signal is transmitted to the final amplifier through a feedback path may also be used, to reduce a gain of a power amplifier.
4. A power supply voltage of a power amplifier is limited to a first voltage threshold Vth1 by using a voltage clamping circuit, so that a gain of a power amplifier is limited.

In addition, the radio frequency front-end module having an overvoltage protection function provided in the present invention may be used in an electronic device, which is used as an important part of a communication component. The electronic device herein refers to a computer device that may be used in a mobile environment and supports various communication standards such as GSM, EDGE, CDMA, TD_SCDMA, WCDMA, TDD_LTE, FDD_LTE, and NR, and includes a mobile phone, a notebook computer, a tablet computer, an on-board computer, and the like. In addition, the technical solutions provided in the present invention are also applicable to occasions of other radio frequency integrated circuit applications, such as a communication base station and an intelligent connected vehicle.

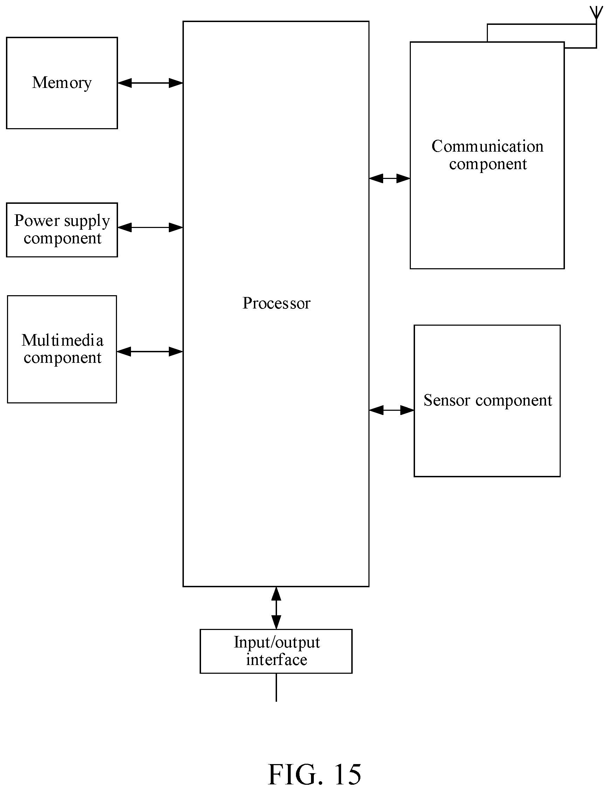

As shown in FIG. 15, the electronic device at least includes a processor, a memory, and a communication component and may further include a sensor component, a power supply component, a multimedia component, and an input/output interface according to an actual requirement. The memory, the communication component, the sensor component, the power supply component, the multimedia component, and the input/output interface are all connected to the processor. The memory may be a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, or the like. The processor may be a central processing unit (CPU), a graphics processing unit (GPU), a field-programmable gate array (FPGA), an application-specific integrated circuit (ASIC), a digital signal processing (DSP) chip, or the like. Another communication component, sensor component, power supply component, multimedia component, and the like may be implemented through a general-purpose component. Details are not described herein.

In summary, compared with the related art, the overvoltage protection method for a radio frequency front-end module provided in the present invention employs the technical solution in which whether the power supply voltage or the power supply voltage and the temperature of the radio frequency front-end module reach set thresholds, the radio frequency front-end module is controlled to enter or exit the OVP protection mode, and related unit circuits are controlled in the OVP protection mode, so as to reduce the gain of the power amplifier or turn off the power amplifier. Therefore, the effective protection on the radio frequency front-end module is achieved. Therefore, the present invention has beneficial effects such as a skillful and proper design, low design costs, high reliability, and good flexibility, effective protection on a radio frequency front-end module is achieved, a failure probability of a mobile communication system is reduced, and a service life of the radio frequency front-end module is improved. The present invention is applicable to various radio frequency front-end modules and electronic devices thereof.

It is to be noted that the foregoing multiple embodiments are merely examples for description. Technical solutions of embodiments may be combined with each other, all of which fall within the protection scope of the present invention.

It is to be noted that terms "first" and "second" are merely used for description, and cannot be construed as indicating or implying relative importance or implicitly indicating a quantity of indicated technical features. Therefore, a feature defined with "first" or "second" may explicitly or implicitly include one or more features. In the descriptions of the present invention, the "plurality of" means two or more, unless otherwise definitely and specifically defined.

The foregoing describes in detail the overvoltage protection method for a radio frequency front-end module and the electronic device provided in the present invention. For a person of ordinary skill in the art, any apparent change made to the present invention without departing from the essential content of the present invention constitutes infringement of the patent right of the present invention, and bears a corresponding legal responsibility.

## Claims

1. An overvoltage protection method for a radio frequency front-end module, comprising the following steps:
(1) monitoring a power supply voltage of the radio frequency front-end module in real time;
(2) proceeding to a next step when the power supply voltage is greater than or equal to a first voltage threshold, or otherwise, continuing monitoring the power supply voltage;
(3) starting counting a first time, wherein the first time is a duration in which the power supply voltage is greater than or equal to the first voltage threshold;
(4) proceeding to a next step when the first time is greater than or equal to the first time threshold;
(5) causing the radio frequency front-end module to enter an overvoltage protection mode, to reduce a gain of a power amplifier or turn off the power amplifier;
(6) proceeding to a next step when the power supply voltage is less than or equal to a fifth voltage threshold, or otherwise, maintaining the overvoltage protection mode;
(7) starting counting a second time, wherein the second time is a duration in which the power supply voltage is less than or equal to the fifth voltage threshold;
(8) proceeding to a next step when the second time is greater than or equal to a second time threshold;
(9) causing the radio frequency front-end module to exit the overvoltage protection mode, to restore the power amplifier to low-gain operation or normal operation; and
(10) returning to step (1), wherein
the first voltage threshold is greater than the fifth voltage threshold.

2. The overvoltage protection method for a radio frequency front-end module according to claim 1, wherein
the method further comprises enabling an overvoltage protection function before step (1).

3. The overvoltage protection method for a radio frequency front-end module according to claim 1, wherein
after the causing the radio frequency front-end module to enter the overvoltage protection mode in step (5), a logic control circuit controls a bias power supply circuit of the power amplifier to be turned off, so that the power amplifier stops operation; and
after the causing the radio frequency front-end module to exit the overvoltage protection mode in step (9), the logic control circuit controls the bias power supply circuit of the power amplifier to be turned on, so that the power amplifier is restored to normal operation.

4. The overvoltage protection method for a radio frequency front-end module according to claim 1, wherein
after the causing the radio frequency front-end module to enter the overvoltage protection mode in step (5), an attenuation enable control circuit enables an attenuation circuit, so that the gain of the power amplifier is reduced; and
after the causing the radio frequency front-end module to exit the overvoltage protection mode in step (9), the attenuation enable control circuit turns off the attenuation circuit, so that the power amplifier is restored to normal operation.

5. The overvoltage protection method for a radio frequency front-end module according to claim 1, wherein
after the causing the radio frequency front-end module to enter the overvoltage protection mode in step (5), the method comprises the following substeps:
a first step of enabling, by an attenuation enable control circuit, an attenuation circuit to reduce the gain of the power amplifier;
a second step of starting counting a third time, wherein the method proceeds to a next step when the third time reaches a third time threshold; and
a third step of controlling, by a logic control circuit, a bias power supply circuit of the power amplifier to be turned off to stop operation of the power amplifier; and
after the causing the radio frequency front-end module to exit the overvoltage protection mode in step (9), the method comprises the following substeps:
a first step of controlling, by the logic control circuit, the bias power supply circuit of the power amplifier to be turned on, and enabling, by the attenuation enable control circuit, the attenuation circuit to restore the low-gain operation of the power amplifier;
a second step of starting counting a fourth time, wherein the method proceeds to a next step when the fourth time reaches a fourth time threshold; and
a third step of turning off, by the attenuation enable control circuit, the attenuation circuit to restore the normal operation of the power amplifier.

6. The overvoltage protection method for a radio frequency front-end module according to claim 1, wherein
after the causing the radio frequency front-end module to enter the overvoltage protection mode in step (5), the method comprises the following substeps:
a first step of turning off a bias power supply of a preamplifier in the power amplifier to reduce the gain of the power amplifier;
a second step of starting counting a third time, wherein the method proceeds to a next step when the third time reaches a third time threshold; and
a third step of turning off a bias power supply of a final amplifier in the power amplifier to stop operation of the power amplifier;
after the causing the radio frequency front-end module to exit the overvoltage protection mode in step (9), the method comprises the following substeps:
a first step of turning on the bias power supply of the final amplifier in the power amplifier to restore the low-gain operation of the power amplifier;
a second step of starting counting a fourth time, wherein the method proceeds to a next step when the fourth time reaches a fourth time threshold; and
a third step of turning on the bias power supply of the preamplifier in the power amplifier to restore the normal operation of the power amplifier.

7. The overvoltage protection method for a radio frequency front-end module according to claim 1, wherein
in addition to the power supply voltage in step (1), a temperature of the radio frequency front-end module is monitored in real time; and
in step (2), determining whether the power supply voltage and a temperature of the radio frequency front-end module reach set thresholds comprises the following substeps:
a first step of proceeding to a next step when the power supply voltage is greater than or equal to the first voltage threshold, wherein otherwise, the power supply voltage and the temperature of the radio frequency front-end module continue to be monitored; and
a second step of proceeding to a next step when the temperature of the radio frequency front-end module is less than or equal to a first temperature threshold or the temperature of the radio frequency front-end module is greater than or equal to a second temperature threshold, wherein otherwise, the power supply voltage and the temperature of the radio frequency front-end module continue to be monitored, wherein
the first temperature threshold is less than the second temperature threshold.

8. The overvoltage protection method for a radio frequency front-end module according to claim 1, wherein
in step (2), when the power supply voltage is greater than or equal to the first voltage threshold, or when a second voltage threshold is less than the power supply voltage which is less than the first voltage threshold, the method proceeds to a next step to start counting a time, and after a counted time satisfies a time threshold, the radio frequency front-end module enters an overvoltage protection mode to reduce the gain of the power amplifier or turn off the power amplifier, and the first voltage threshold is greater than the second voltage threshold.

9. The overvoltage protection method for a radio frequency front-end module according to claim 1, wherein
in step (6), when the power supply voltage is less than or equal to the fifth voltage threshold, or when the fifth voltage threshold is less than the power supply voltage which is less than a fourth voltage threshold, the method proceeds to a next step to start counting a time, and after a counted time satisfies a time threshold, the radio frequency front-end module exits the overvoltage protection mode, so that the power amplifier is restored to the low-gain operation or the normal operation, and the fourth voltage threshold is greater than the fifth voltage threshold.

10. The overvoltage protection method for a radio frequency front-end module according to claim 8, wherein
in step (2), when the power supply voltage is greater than or equal to the first voltage threshold, or the second voltage threshold is less than the power supply voltage which is less than the first voltage threshold, and a temperature of the radio frequency front-end module is less than or equal to a first temperature threshold or the temperature of the radio frequency front-end module is greater than or equal to a second temperature threshold, the method proceeds to a next step to start counting a time, and after a counted time satisfies the time threshold, the radio frequency front-end module enters the overvoltage protection mode to reduce the gain of the power amplifier or turn off the power amplifier; wherein the first voltage threshold is greater than the second voltage threshold, and the first temperature threshold is less than the second temperature threshold.

11. The overvoltage protection method for a radio frequency front-end module according to claim 1, wherein
after the causing the radio frequency front-end module to enter the overvoltage protection mode in step (5), a voltage clamping circuit is turned on to provide a clamped power supply voltage to the power amplifier, so that the gain of the power amplifier is limited; and
after the causing the radio frequency front-end module to exit the overvoltage protection mode in step (9), the voltage clamping circuit is turned off to provide a normal power supply voltage to the power amplifier, so that the power amplifier is restored to normal operation.

12. The overvoltage protection method for a radio frequency front-end module according to any one of claims 4 to 6, wherein
after the causing the radio frequency front-end module to enter the overvoltage protection mode in step (5), an output voltage of the bias power supply circuit of the power amplifier is adjusted to a low-voltage level to change a direct current operating point of the power amplifier, so that the gain of the power amplifier is reduced.

13. A radio frequency front-end module having an overvoltage protection function, comprising at least a power amplifier, an output matching circuit, and an analog control circuit, and the analog control circuit comprising at least a voltage monitoring and comparison circuit, a bias power supply circuit, and a logic control circuit, wherein
an output end of the power amplifier is connected to the output matching circuit;
the voltage monitoring and comparison circuit is configured to monitor a power supply voltage, compare the power supply voltage with a set threshold voltage, and generate, when a monitored voltage reaches a voltage threshold, a control signal that is supplied to the logic control circuit;
the bias power supply circuit is configured to provide a power supply to the bias circuit of the power amplifier;
the logic control circuit is configured to perform function control and an adjustment of an electrical parameter on the radio frequency front-end module;
the radio frequency front-end module enters an overvoltage protection mode when the power supply voltage is greater than or equal to a first voltage threshold, and the analog control circuit reduces a gain of the power amplifier or turns off the power amplifier; and the radio frequency front-end module exits the overvoltage protection mode when the power supply voltage is less than or equal to a fifth voltage threshold, and the analog control circuit enables the power amplifier to restore low-gain operation or normal operation, to implement overvoltage protection for the radio frequency front-end module.

14. The radio frequency front-end module having an overvoltage protection function according to claim 13, wherein
the radio frequency front-end module further comprises an attenuation circuit, and the analog control circuit further comprises a timer and an attenuation enable control circuit;
the attenuation circuit is connected to an input end of the power amplifier;
the radio frequency front-end module enters the overvoltage protection mode with a delay of a preset time period when the power supply voltage is greater than or equal to the first voltage threshold, and the attenuation enable control circuit performs control to enable the attenuation circuit to reduce the gain of the power amplifier; and
the radio frequency front-end module exits the overvoltage protection mode with the delay of the preset time period when the power supply voltage is less than or equal to the fifth voltage threshold, and the attenuation enable control circuit performs control to turn off the attenuation circuit to restore the power amplifier to the normal operation.

15. The radio frequency front-end module having an overvoltage protection function according to claim 13, wherein
the analog control circuit further comprises a temperature monitoring circuit, configured to monitor a temperature of the radio frequency front-end module and compare the temperature with a set temperature threshold; and
the radio frequency front-end module enters the overvoltage protection mode when the power supply voltage is greater than or equal to the first voltage threshold, and the temperature of the radio frequency front-end module is less than or equal to a first temperature threshold or the temperature of the radio frequency front-end module is greater than or equal to a second temperature threshold, and the analog control circuit reduces the gain of the power amplifier or turns off the power amplifier.

16. The radio frequency front-end module having an overvoltage protection function according to claim 15, wherein
the analog control circuit further comprises a voltage clamping circuit, and a power supply source supplies power to the power amplifier through the voltage clamping circuit; and
the radio frequency front-end module enters the overvoltage protection mode when the power supply voltage is greater than or equal to the first voltage threshold, and the temperature of the radio frequency front-end module is less than or equal to the first temperature threshold or the temperature of the radio frequency front-end module is greater than or equal to the second temperature threshold, and the voltage clamping circuit limits the power supply voltage of the power amplifier to the first voltage threshold, so that the gain of the power amplifier is limited.

17. The radio frequency front-end module having an overvoltage protection function according to claim 13, wherein
after the radio frequency front-end module enters the overvoltage protection mode, in a power amplifier circuit formed by multi-stage power amplifiers, a bias power supply of a preamplifier is turned off, only a final amplifier is kept to operate, and a radio frequency signal is transmitted to the final amplifier through a feedback path, thereby reducing the gain of the power amplifier.

18. The radio frequency front-end module having an overvoltage protection function according to claim 13, wherein
after the radio frequency front-end module enters the overvoltage protection mode, an output voltage of the bias power supply circuit is adjusted to a low-voltage level to change a direct current operating point of the power amplifier, thereby reducing the gain of the power amplifier.

19. The radio frequency front-end module having an overvoltage protection function according to claim 14, wherein
the attenuation circuit comprises a first capacitor, a first transistor, a first resistor, and a second resistor; a collector of the first transistor is connected to a radio frequency signal input end through the first capacitor, and an emitter of the first transistor is connected to a ground potential terminal; two ends of the first resistor are connected across the collector and a base of the first transistor; and an attenuation enabling control signal end is connected to the base of the first transistor through the second resistor.

20. The radio frequency front-end module having an overvoltage protection function according to claim 14, wherein
the attenuation circuit is connected to a radio frequency switch branch in parallel, and after the parallel connection, an end of the attenuation circuit is connected to a radio frequency signal input end, and the other end of the attenuation circuit is connected to the input end of the power amplifier; and a control end of a radio frequency switch in the radio frequency switch branch is connected to an attenuation enabling control signal end.

21. An electronic device, comprising the radio frequency front-end module having an overvoltage protection function according to any one of claims 13 to 20.
